(19) Europäisches Patentamt
European Patent Office
Office européen des brevets

(11) **EP 2 538 538 B1**

(12) **FASCICULE DE BREVET EUROPEEN**

(45) Date de publication et mention
de la délivrance du brevet:
**27.02.2019 Bulletin 2019/09**

(51) Int Cl.:
***H02M 3/335*** *(2006.01)*    ***H02M 7/00*** *(2006.01)*
***H05K 1/02*** *(2006.01)*

(21) Numéro de dépôt: **12305704.4**

(22) Date de dépôt: **21.06.2012**

(54) **Carte de circuit imprimé pour boîtier de compresseur**

Leiterplatte für Kompressorgehäuse

Printed circuit board for a compressor housing

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.06.2011 FR 1101967**

(43) Date de publication de la demande:
**26.12.2012 Bulletin 2012/52**

(73) Titulaire: **Valeo Japan Co., Ltd.**
**Saitama 360-0193 (JP)**

(72) Inventeurs:
• **Sardat, Pierre**
**93340 Le Raincy (FR)**

• **Hadjelis, Bruno**
**95310 Saint Ouen l'Aumone (FR)**
• **Lescot, Hubert**
**95610 Eragny (FR)**

(74) Mandataire: **Cardon, Nicolas**
**VALEO SYSTEMES DE CONTROLE MOTEUR**
**Service Propriété Intellectuelle**
**Immeuble Le Delta**
**14, avenue des Béguines**
**BP 68532 Cedex**
**95892 Cergy-Pontoise (FR)**

(56) Documents cités:
**US-A- 5 675 223    US-A- 5 815 381**
**US-A- 5 949 659    US-A1- 2006 017 426**

EP 2 538 538 B1

**Description**

La présente invention se rapporte à une carte de circuit imprimé, notamment pour un boîtier de compresseur.

L'invention s'intéresse plus particulièrement au domaine des compresseurs commandés électriquement, utilisés notamment dans les systèmes de climatisation des véhicules automobiles.

Ces compresseurs sont commandés à l'aide d'un microcontrôleur intégré sur une carte de circuit imprimé disposée sur un boîtier du compresseur.

Cette carte de circuit imprimé comprend généralement trois portions :

- une première portion ayant des premiers composants électroniques dont la masse de référence est sur une première source de tension ;
- une deuxième portion ayant des deuxièmes composants électroniques dont la masse de référence est sur une deuxième source de tension ; et
- une troisième portion, formant barrière de potentiel, intercalée entre la première et la deuxième portions.

Sur cette carte, le microcontrôleur est intégré sur la deuxième portion tout en étant alimenté par la première source de tension par l'intermédiaire d'une alimentation à découpage. L'ordre de couper cette alimentation à découpage est donné par le microcontrôleur.

Typiquement, ce microcontrôleur reçoit depuis un bus CAN du véhicule un signal de données comprenant l'ordre d'arrêt de l'alimentation. Le microcontrôleur reçoit également un deuxième signal, dit signal APC ou « wake-up », comprenant un ordre de mise sous tension/réveil ou de démarrage de l'alimentation. Ce deuxième signal est câblé indépendamment du premier signal.

Pour des raisons de fiabilité, le microcontrôleur doit surveiller ce signal APC afin d'éviter un conflit entre les ordres d'arrêt et de démarrage reçus pouvant entraîner des dommages au niveau de la carte de circuit imprimé.

Le deuxième signal est transmis de la première portion à la deuxième portion à travers un composant d'isolation situé au niveau de la barrière de potentiel. Généralement, le composant d'isolation utilisé est un optocoupleur.

Cependant, l'utilisation d'un optocoupleur présente plusieurs inconvénients.

En effet, l'utilisation d'un optocoupleur dans une application automobile n'est pas aisée en raison de problèmes de fiabilité de ce composant qui n'est pas qualifié pour le secteur automobile. De plus, l'ajout de composants représente un volume et un poids supplémentaires.

En outre, les optocoupleurs sont coûteux et ont une durée de vie limitée. L'invention se propose d'améliorer la situation.

Le but de la présente invention est donc d'éviter l'utilisation d'un composant d'isolation.

Le document US5949659 décrit un dispositif selon le préambule de la revendication 1.

L'invention concerne tout d'abord une carte de circuit imprimé selon la revendication 1.

Par exemple, la première source de tension délivre une tension inférieure à celle de la deuxième tension. Dans un exemple particulier, la première source de tension est une basse tension et la deuxième source de tension est une haute tension. Notamment, dans le cadre de la présente demande, une basse tension désigne une tension inférieure à 60V et une haute tension désigne une tension supérieure à 60V.

Ainsi, la présente invention permet de transmettre le signal de données sans passer par un composant d'isolation en modifiant la fréquence de découpage du circuit d'alimentation.

Avantageusement, la carte comprend des moyens de mesure de la fréquence de découpage en sortie du circuit d'alimentation.

De préférence, les moyens de mesure comprennent un circuit d'adaptation raccordé à la sortie.

Avantageusement, la carte comprend des moyens de détermination de la valeur des données en fonction de la fréquence de découpage mesurée.

De préférence, les moyens de détermination de la valeur des données comprennent un microcontrôleur.

Avantageusement, le circuit d'alimentation à découpage comprend un transformateur dont le primaire est raccordé à l'entrée et le secondaire est raccordé à la sortie.

Selon une caractéristique préférée, les moyens de modification comprennent une première résistance et un condensateur. Avantageusement, à chaque valeur distincte des données correspond une plage de fréquences de découpage distincte.

Selon une première réalisation, le signal de données est un signal logique et le nombre de plages de fréquences de découpage distinctes est égal à 2.

A titre d'exemple, le signal de données est un signal APC (« APrès Contact »).

De préférence, les moyens de modification comprennent, dans ce cas, un transistor MOS et une deuxième résistance raccordés en série parallèlement à la première résistance, la grille du transistor MOS étant raccordée au signal de données.

Selon une deuxième réalisation, le signal de données est un signal numérique codé sur N bits et le nombre de plages de fréquences de découpage distinctes est égal à $2^N$.

Selon une troisième réalisation, le signal de données est un signal analogique.

Avantageusement, les moyens de mesure de la fréquence de découpage comprennent des moyens de mesure de la tension du secondaire.

L'invention concerne aussi un procédé selon la revendication 7.

L'invention concerne également un boîtier de compresseur comprenant une carte de circuit imprimé selon l'invention.

D'autres caractéristiques, détails et avantages de l'invention ressortiront plus clairement à la lecture de la description donnée ci-après à titre indicatif en relation avec des dessins dans lesquels :

- la figure 1 est un schéma illustrant la structure d'un compresseur pour véhicule automobile ;
- la figure 2 est un schéma illustrant la structure détaillée d'un exemple de carte de circuit imprimé selon un mode de réalisation de l'invention ;
- la figure 3 est un schéma illustrant la structure d'un exemple de circuit d'alimentation à découpage de la carte selon un mode de réalisation de l'invention ;
- la figure 4 est un graphique illustrant le fonctionnement d'un exemple de circuit d'alimentation à découpage ;
- la figure 5 est un schéma illustrant la structure d'un exemple de moyens de détermination de fréquence de découpage de la carte selon un mode de réalisation de l'invention ; et
- la figure 6 est un schéma illustrant la structure d'un exemple de circuit d'adaptation d'impédance de la carte selon un mode de réalisation de l'invention.

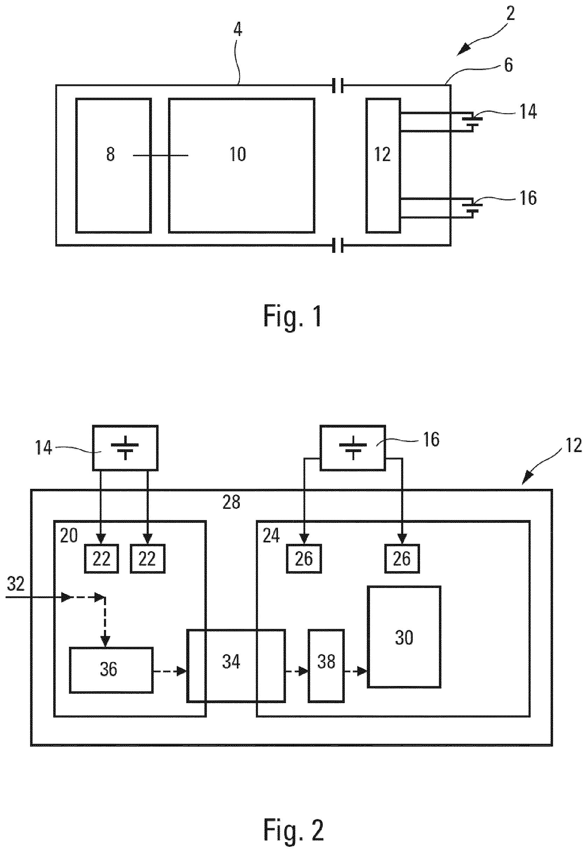

La figure 1 représente un compresseur 2 d'un dispositif de climatisation pour véhicule automobile dans lequel la présente invention peut être mise en oeuvre.

Le compresseur 2 comprend un premier boîtier 4 et un deuxième boîtier 6.

Le premier boîtier 4 comprend un mécanisme de compression 8 à entraînement électrique.

Le premier boîtier 4 comprend également un moteur électrique 10 pour l'entraînement du mécanisme de compression 8.

Le deuxième boîtier 6, généralement en aluminium, comprend une carte de circuit imprimé 12 dite carte PCB (selon l'acronyme anglais « Printed Circuit Board ») pour la commande du mécanisme de compression 8. Cette carte PCB forme notamment un onduleur qui alimente et commande le moteur électrique 10.

La carte PCB 12 est apte à être alimentée en basse tension et en haute tension par une alimentation basse tension 14 et une alimentation haute tension 16, respectivement.

Une basse tension désigne une tension comprise inférieure à 60V, typiquement égale à 12V, et une haute tension désigne une tension supérieure à 60V, typiquement égale à 300V. La basse tension correspond à la tension disponible sur un réseau sécurisé du véhicule alors que la haute tension provient d'une source électrique qui alimente également un moteur électrique chargé d'animer le déplacement du véhicule.

La figure 2 illustre la structure détaillée de la carte 12 selon un mode de réalisation préféré de l'invention.

La carte 12 comprend trois portions distinctes.

La première portion 20 de la carte 12 supporte des premiers composants électroniques 22 aptes à être alimentés en basse tension par l'alimentation basse tension 14.

La deuxième portion 24 de la carte 12 supporte des deuxièmes composants électroniques 26 aptes à être alimentés en haute tension par l'alimentation haute tension 16.

La troisième portion 28 est intercalée entre la première portion 20 et la deuxième portion 24. Elle forme une barrière de potentiel entre les deux portions 20, 24. Par exemple, cette troisième portion 28 est dépourvue de pistes électriques et présente de préférence une largeur minimum de 4,5 mm.

La deuxième portion 24 comprend également un microcontrôleur 30 apte à recevoir un signal de données 32 depuis la première portion 20 par l'intermédiaire d'un circuit d'alimentation à découpage 34 dont une entrée est raccordée à la première portion 20 et dont une sortie est raccordée à la deuxième portion 24.

La première portion 20 comprend aussi des moyens de modification 36 permettant de varier la fréquence de découpage du circuit d'alimentation 34 en fonction du signal de données 32.

En outre, la deuxième portion 24 comprend un circuit d'adaptation d'impédance 38 destiné à adapter la sortie du circuit d'alimentation à découpage 34 à l'entrée du microcontrôleur 30.

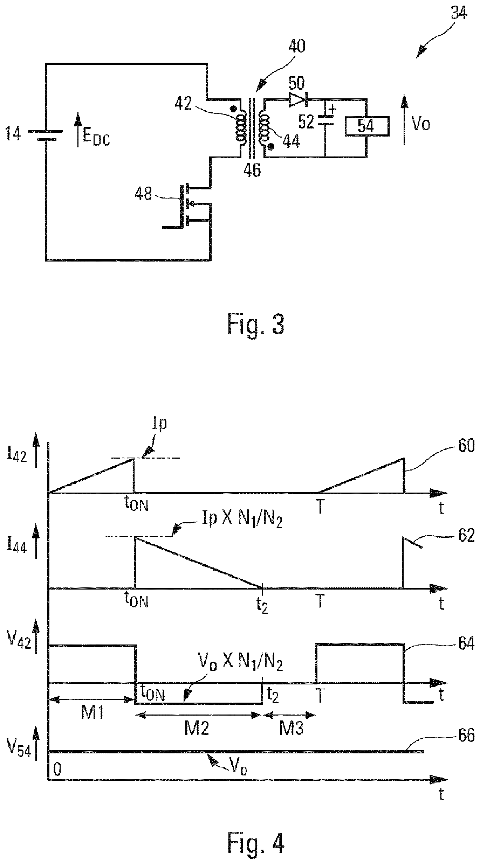

La figure 3 illustre la structure du circuit d'alimentation à découpage 34 selon un mode de réalisation préféré de l'invention.

Selon ce mode préféré, le circuit d'alimentation à découpage 34 est un convertisseur Flyback comprenant un transformateur 40 comprenant une première inductance 42 et une deuxième inductance 44 couplées.

La première inductance 42, de valeur $L_1$ et ayant un nombre de spires égal à N1, constitue le primaire du transformateur 40. Elle est raccordée à la première portion 20 de la carte 12.

La deuxième inductance 44, de valeur $L_2$ et ayant un nombre de spires égal à N2, constitue le secondaire du transformateur 40. Elle est raccordée à la deuxième portion 24 de la carte 12.

Une isolation galvanique 46 sépare le primaire 42 et le secondaire 44.

Le primaire 42 est alimenté par l'alimentation basse tension 14 par l'intermédiaire d'un interrupteur 48 comprenant un transistor MOSFET, par exemple.

Le secondaire 44 est raccordé à une diode 50, elle-même raccordée à un condensateur 52 raccordé en parallèle à une charge 54 comprenant notamment le circuit d'adaptation d'impédance 38 et le microcontrôleur 30.

Le fonctionnement du circuit d'alimentation à découpage 34 est détaillé en référence aux courbes 60, 62, 64, 66 de la figure 4 qui illustrent respectivement l'évolution du courant du primaire $I_{42}$, du courant du secondaire $I_{44}$, de la tension du primaire $V_{42}$ et de la tension de la charge $V_{54}$ en fonction du temps.

Le circuit d'alimentation à découpage 34 fonctionne, selon une période de découpage T, conformément à un rapport cyclique prédéterminé égal à $\alpha = t_{ON}/T$, $t_{ON}$ représentant la durée pendant laquelle l'interrupteur 48 conduit.

La tension de la charge $V_{54}$ est constante et égale à $V_0 = \dfrac{N2}{N1}\dfrac{\alpha}{1-\alpha}E_{DC}$, où $E_{DC}$ est la tension délivrée par l'alimentation basse tension 14, $\alpha$ est le rapport cyclique du circuit d'alimentation, N1 est le nombre de spires du primaire 42 et N2 est le nombre de spires du secondaire 44.

Dans l'état passant, pour le temps t compris entre 0 et $t_{ON}$, l'interrupteur 48 est fermé. Le primaire 42 du transformateur 40 est relié directement à l'alimentation 14, de sorte que la tension $V_{42}$ du primaire est égale à la tension $E_{DC}$ générée par l'alimentation 14. Il en résulte une augmentation du flux magnétique dans le transformateur 40. Le courant $I_{42}$ du primaire 42 augmente alors selon la relation $I_{42} = \dfrac{E_{DC}}{L_1}t$, où t représente le temps, $E_{DC}$ est la tension délivrée par l'alimentation basse tension 14 et $L_1$ la valeur de l'inductance du primaire 42.

A la fin de l'état passant $I_{42}$ atteint sa valeur maximale $I_P = \dfrac{E_{DC}}{L_1}t_{ON}$, où $t_{ON}$ représente la durée pendant laquelle l'interrupteur 48 conduit, $E_{DC}$ est la tension délivrée par l'alimentation basse tension 14 et $L_1$ la valeur de l'inductance du primaire 42.

En outre, $I_P$ est fonction de la puissance P des composants raccordés au secondaire 44 selon la relation

$$I_P = \sqrt{\dfrac{2*P}{L_1 * F_d}}$$ où $F_d$ est la fréquence de découpage du convertisseur. Il est ainsi possible de déterminer la durée $t_{ON}$ à partir de la puissance P.

Selon un exemple de réalisation non représenté, le transformateur comprend deux secondaires. La puissance P est obtenue, selon cet exemple, grâce à un secondaire raccordé à la masse de la première portion couplé avec un secondaire raccordé à la masse de la deuxième portion et alimentant le microprocesseur.

Il est remarquable que lorsque la fréquence de découpage $F_d$ est modifiée, le circuit d'alimentation à découpage continue à assurer sa fonction de découpage. En effet, quand la fréquence $F_d$ augmente, le courant $I_P$ diminue et quand la fréquence $F_d$ diminue, le courant $I_P$ augmente. Ainsi, l'énergie transmise au secondaire 44 reste constante.

En revenant à la figure 3, dans l'état passant, la tension aux bornes du secondaire 44 est négative, bloquant ainsi la diode 50, de sorte que le courant du secondaire $I_{44}$ est nul. C'est le condensateur 52 qui fournit l'énergie demandée par la charge 54.

A la fin de l'état passant, au temps $t_{ON}$, l'interrupteur 48 s'ouvre empêchant ainsi le courant du primaire $I_{42}$ de continuer à circuler. La conservation de l'énergie stockée dans le transformateur 40 provoque l'apparition d'un courant $I_{44}$ dans le secondaire 44 du transformateur 40, dont la valeur initiale est égale à $I_P \times N1/N2$. Le courant $I_{44}$ est donné par la relation

$$I_{44} = I_P \times N1/N2 - \dfrac{V_0}{L_2}\left(t - t_{ON}\right).$$ $I_{44}$ s'annule à $t=t_2$.

La tension du primaire $V_{42}$, entre $t_{ON}$ et $t_2$, est donnée par la relation $V_{42} = -\dfrac{N1}{N2}V_0$. Elle est nulle entre $t_2$ et T.

Ainsi, au cours d'une période, le circuit d'alimentation à découpage fonctionne selon 3 modes distincts : un premier mode M1 pour le temps compris entre 0 et $t_{ON}$, un deuxième mode M2 pour le temps compris entre $t_{ON}$ et $t_2$ et un troisième mode M3 pour le temps compris entre $t_2$ et T.

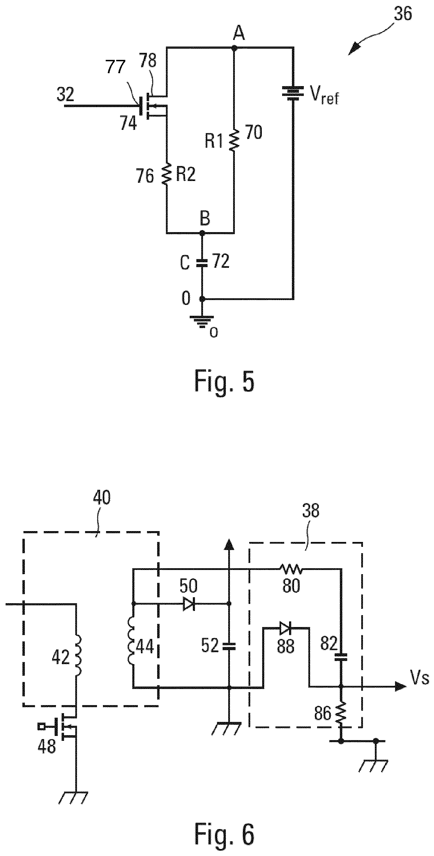

La figure 5 détaille la structure des moyens de modification 36 de la fréquence de découpage lorsque le signal de données 32 est un signal logique pouvant prendre uniquement deux valeurs 0 et 1, par exemple le signal APC. Les moyens de modification modifient la fréquence de découpage d'un oscillateur interne au circuit d'alimentation à découpage 34. Cet oscillateur, non représenté, est raccordé aux points A, B et O de la figure 5.

Les moyens de détermination 36 comprennent une première résistance R1 70 raccordée en série à un condensateur C 72.

Un transistor MOS 74 et une deuxième résistance R2 76, en série avec le transistor 74, sont raccordés en parallèle à la résistance 70.

L'entrée du signal de données 32 est raccordée à la grille 77 du transistor MOS 74 afin de commuter ce transistor 74, ce qui a pour effet de modifier la constante de temps de l'oscillateur. La fréquence de découpage du circuit d'alimentation 34 est alors également modifiée.

Le drain 78 du transistor 74 est raccordé à une tension $V_{ref}$, par exemple égale à 5V.

Deux constantes de temps sont possibles R1*C et $\left(\dfrac{R1 * R2}{R1 + R2}\right)*C$ résultant en deux fréquences de découpage distinctes.

A titre d'exemple, en choisissant C = 1nF, R1 = 15,4kΩ et R2 = 59kΩ, les deux fréquences de découpage résultantes sont F1 = 53kHz et F2 = 66kHz. Par exemple, la fréquence F1 correspond à une valeur du signal APC égale à 1 et la fréquence F2 correspond à une valeur du signal APC égale à 0.

En fonction des tolérances des composants et de la température, les fréquences de découpage F1 et F2 peuvent avoir de légères dérives.

En reprenant l'exemple précédent, F1 est comprise entre 48kHz et 60kHz et F2 est comprise entre 60kHz et 75kHz.

Les fréquences de découpage F1 et F2 sont mesurées en sortie du circuit d'alimentation 34 à l'aide d'une mesure de la tension au secondaire 44 du transformateur 40.

Le microcontrôleur 30 détermine ensuite les valeurs du signal APC à partir des fréquences de découpage.

Le circuit d'adaptation d'impédance 38 permet de filtrer et d'adapter la sortie du circuit d'alimentation 34 à l'entrée du microcontrôleur 30 afin de mesurer la fréquence de découpage de l'alimentation.

La structure du circuit d'adaptation d'impédance 38 apparaît de manière plus détaillée sur la figure 6.

Le circuit d'adaptation 38 comprend :

- une résistance 80 raccordée en série à un condensateur 82 ; et
- une résistance 86 raccordée en série à l'ensemble formé par la résistance 80 et le condensateur 82.

A partir de la tension de sortie Vs mesurée aux bornes de la résistance 86, le microcontrôleur 30 détermine les valeurs du signal de données.

De préférence, le circuit d'adaptation 38 comprend également une diode 88 raccordée en parallèle à l'ensemble de la résistance 80 et du condensateur 82 pour limiter la tension de sortie Vs à une valeur acceptable pour l'entrée du microcontrôleur 30.

D'autres modes de réalisation peuvent encore être envisagés.

Ainsi, lorsque le signal de données est un signal numérique à N bits, les moyens de modification comprennent plusieurs circuits raccordés en parallèle entre les points A et B sur la figure 5, dont chacun est formé par un transistor 74 et une résistance 76 en série. Le nombre de circuits raccordés en parallèle est fonction du nombre de bits de signal de données à transmettre. Par exemple, en mettant en oeuvre N circuits en parallèle, il est possible de transmettre un signal de données de $2^N$ bits.

Lorsque le signal de données est analogique, l'oscillateur comprend un circuit formant résistance variable, par exemple un miroir de courant. Le signal analogique correspond par exemple à une information de température mesurée du côté de la première portion et transmise au microcontrôleur 30 dans la deuxième portion pour être traitée. Dans un exemple particulier, le signal analogique est lentement variable au regard de la fréquence de découpage, ce qui assure que les valeurs du signal de données 32 correspondent à des fréquences respectives différentes.

Bien entendu, d'autres modes de réalisation peuvent être envisagés.

Ainsi, le principe de l'invention consistant à transmettre un signal de données sans passer par un composant d'isolation en modifiant la fréquence de découpage peut être utilisé pour toutes les applications ayant besoin de transmettre des données entre deux portions de circuit raccordées à deux masses flottantes quelconques et/ou entre plusieurs portions de circuit dont une portion est raccordée une masse primaire et les autres portions sont raccordées à des masses secondaires flottantes entre elles.

La carte selon l'invention a été décrite dans un exemple dans lequel l'alimentation à découpage est un convertisseur Flyback. Cependant la carte selon l'invention peut comprendre un autre type d'alimentation à découpage.

**Revendications**

1. Carte (12) de circuit imprimé comprenant :

   - une première portion (20) ayant des premiers composants électroniques (22) dont la masse de référence est sur une première source de tension (14) ;
   - une deuxième portion (24) ayant des deuxièmes composants électroniques (26) dont la masse de référence est sur une deuxième source de tension (16) ;
   - un circuit d'alimentation à découpage (34) dont une entrée est raccordée à la première portion (20) et dont au moins une sortie est raccordée à la deuxième portion (24) ;
   - des moyens de modification (36) d'une fréquence de découpage du circuit d'alimentation à découpage (34) en fonction de valeurs de données (32) à transmettre entre la première portion (20) et la deuxième portion (24), lesdites données pouvant prendre au moins deux valeurs distinctes,

   **caractérisée en ce que** les moyens de modification (36) comprennent une première résistance (70) et un condensateur (72),
   à chaque valeur distincte des données correspond une plage de fréquences de découpage distincte,
   le signal de données (32) est un signal logique et le nombre de plages de fréquences de découpage distinctes est égal à 2, et
   les moyens de modification (36) comprennent un transistor MOS (74) et une deuxième résistance (76) raccordés en série parallèlement à la première résistance (70), la grille du transistor MOS (74) étant raccordée au signal de données (32).

2. Carte selon la revendication 1, comprenant des moyens de mesure de la fréquence de découpage en sortie du circuit d'alimentation (34).

**3.** Carte selon la revendication 2, dans laquelle les moyens de mesure comprennent un circuit d'adaptation (38) raccordé à la sortie.

**4.** Carte selon la revendication 2 ou 3, comprenant des moyens de détermination de la valeur des données en fonction de la fréquence de découpage mesurée.

**5.** Carte selon la revendication 4, dans laquelle les moyens de détermination de la valeur des données comprennent un microcontrôleur (30).

**6.** Carte selon l'une quelconque des revendications précédentes, dans laquelle le circuit d'alimentation à découpage (34) comprend un transformateur (40) dont le primaire (42) est raccordé à l'entrée et le secondaire (44) est raccordé à la sortie.

**7.** Procédé de communication de données d'une carte (12) de circuit imprimé, ladite carte (12) comprenant :

- une première portion (20) ayant des premiers composants électroniques (22) dont la masse de référence est sur une première source de tension (14) ;
- une deuxième portion (24) ayant des deuxièmes composants électroniques (26) dont la masse de référence est sur une deuxième source de tension (16) ;
- un circuit d'alimentation à découpage (34) dont une entrée est raccordée à la première portion (20) et dont au moins une sortie est raccordée à la deuxième portion (24) ;le procédé comprenant une étape de modification d'une fréquence de découpage du circuit d'alimentation à découpage (34) en fonction de valeurs de données (32) à transmettre entre la première portion (20) et la deuxième portion (24), lesdites données pouvant prendre au moins deux valeurs distinctes,

ladite étape de modification étant réalisée par des moyens de modification d'une fréquence de découpage du circuit d'alimentation à découpage (34) en fonction de valeurs de données (32) à transmettre entre la première portion (20) et la deuxième portion (24), lesdit moyens de modification (36) comprenantt une première résistance (70) et un condensateur (72),
à chaque valeur distincte des données correspond une plage de fréquences de découpage distincte,
le signal de données (32) est un signal logique et le nombre de plages de fréquences de découpage distinctes est égal à 2, et
les moyens de modification (36) comprenant un transistor MOS (74) et une deuxième résistance (76) raccordés en série parallèlement à la première résistance (70), la grille du transistor MOS (74) étant raccordée au signal de données (32).

**8.** Boîtier de compresseur (6) comprenant une carte de circuit imprimé (12) selon l'une quelconque des revendications 1 à 6.


**Patentansprüche**

**1.** Leiterplatte (12), umfassend:

- einen ersten Abschnitt (20), der erste elektronische Komponenten (22) aufweist, dessen Bezugsmasse auf einer ersten Spannungsquelle (14) liegt;
- einen zweiten Abschnitt (24), der zweite elektronische Komponenten (26) aufweist, dessen Bezugsmasse auf einer zweiten Spannungsquelle (16) liegt;
- eine Schaltnetzteilschaltung (34), von der ein Eingang an den ersten Abschnitt (20) angeschlossen ist, und von der mindestens ein Ausgang an den zweiten Abschnitt (24) angeschlossen ist;
- Mittel zum Ändern (36) einer Schaltfrequenz der Schaltnetzteilschaltung (34) in Abhängigkeit von Werten von Daten (32), die zwischen dem ersten Abschnitt (20) und dem zweiten Abschnitt (24) zu übertragen sind, wobei die Daten mindestens zwei separate Werte annehmen können, **dadurch gekennzeichnet, dass** die Mittel zum Ändern (36) einen ersten Widerstand (70) und einen Kondensator (72) umfassen,

jedem separaten Wert der Daten ein separater Schaltfrequenzbereich entspricht,
das Signal von Daten (32) ein logisches Signal ist und die Anzahl von separaten Schaltfrequenzbereichen gleich 2 ist, und
die Mittel zum Ändern (36) einen MOS-Transistor (74) und einen zweiten Widerstand (76) umfassen, die parallel zum ersten Widerstand (70) in Reihe geschaltet sind, wobei das Gate des MOS-Transistors (74) an das Signal von Daten (32) angeschlossen ist.

**2.** Leiterplatte nach Anspruch 1, umfassend Mittel zum Messen der Schaltfrequenz am Ausgang der Netzteilschaltung (34).

**3.** Leiterplatte nach Anspruch 2, wobei die Mittel zum Messen eine Anpassungsschaltung (38) umfassen, die an den Ausgang angeschlossen ist.

**4.** Leiterplatte nach Anspruch 2 oder 3, umfassend Mittel zum Bestimmen des Werts der Daten in Abhängigkeit von der gemessenen Schaltfrequenz.

**5.** Leiterplatte nach Anspruch 4, wobei die Mittel zum

11     **EP 2 538 538 B1**     12

Bestimmen des Werts der Daten einen Mikrocontroller (30) umfassen.

6. Leiterplatte nach einem der vorhergehenden Ansprüche, wobei die Schaltnetzteilschaltung (34) einen Transformator (40) umfasst, dessen Primärseite (42) an den Eingang angeschlossen ist und dessen Sekundärseite (44) an den Ausgang angeschlossen ist.

7. Verfahren zur Kommunikation von Daten einer Leiterplatte (12), die Leiterplatte (12) umfassend:

- einen ersten Abschnitt (20), der erste elektronische Komponenten (22) aufweist, dessen Bezugsmasse auf einer ersten Spannungsquelle (14) liegt;
- einen zweiten Abschnitt (24), der zweite elektronische Komponenten (26) aufweist, dessen Bezugsmasse auf einer zweiten Spannungsquelle (16) liegt;
- eine Schaltnetzteilschaltung (34), von der ein Eingang an den ersten Abschnitt (20) angeschlossen ist, und von der mindestens ein Ausgang an den zweiten Abschnitt (24) angeschlossen ist; das Verfahren umfassend einen Schritt des Änderns einer Schaltfrequenz der Schaltnetzteilschaltung (34) in Abhängigkeit von Werten von Daten (32), die zwischen dem ersten Abschnitt (20) und dem zweiten Abschnitt (24) zu übertragen sind, wobei die Daten mindestens zwei separate Werte annehmen können, wobei der Schritt des Änderns durch Mittel zum Ändern einer Schaltfrequenz der Schaltnetzteilschaltung (34) in Abhängigkeit von Werten von Daten (32) durchgeführt wird, die zwischen dem ersten Abschnitt (20) und dem zweiten Abschnitt (24) zu übertragen sind, wobei die Mittel zum Ändern (36) einen ersten Widerstand (70) und einen Kondensator (72) umfassen,

jedem separaten Wert der Daten ein separater Schaltfrequenzbereich entspricht, das Signal von Daten (32) ein logisches Signal ist und die Anzahl von separaten Schaltfrequenzbereichen gleich 2 ist, und die Mittel zum Ändern (36) einen MOS-Transistor (74) und einen zweiten Widerstand (76) umfassen, die parallel zum ersten Widerstand (70) in Reihe geschaltet sind, wobei das Gate des MOS-Transistors (74) an das Signal von Daten (32) angeschlossen ist.

8. Kompressorgehäuse (6), umfassend eine Leiterplatte (12) nach einem der Ansprüche 1 bis 6.

**Claims**

1. Printed circuit board (12) comprising:

- a first portion (20) having first electronic components (22) of which the earth electrode is on a first voltage source (14);
- a second portion (24) having second electronic components (26) of which the earth electrode is on a second voltage source (16);
- a switched-mode power supply circuit (34) of which one input is connected to the first portion (20) and of which at least one output is connected to the second portion (24);
- modification means (36) for modifying a switching frequency of the switched-mode power supply circuit (34) depending on data values (32) to be transmitted between the first portion (20) and the second portion (24), the said data being able to take at least two distinct values,

**characterized in that**
the modification means (36) comprise a first resistor (70) and a capacitor (72),
each distinct value of the data corresponds to a distinct range of switching frequencies,
the data signal (32) is a logic signal and the number of distinct switching frequency ranges is equal to 2, and
the modification means (36) comprise an MOS transistor (74) and a second resistor (76) both being connected in series parallel to the first resistor (70), the gate of the MOS transistor (74) being connected to the data signal (32).

2. Board according to Claim 1, comprising means for measuring the switching frequency at the output of the power supply circuit (34).

3. Board according to Claim 2, in which the measurement means comprise a matching circuit (38) connected to the output.

4. Board according to Claim 2 or 3, comprising means for determining the value of the data depending on the measured switching frequency.

5. Board according to Claim 4, in which the means for determining the value of the data comprise a microcontroller (30).

6. Board according to any one of the preceding claims, in which the switched-mode power supply circuit (34) comprises a transformer (40) of which the primary (42) is connected to the input and the secondary (44) is connected to the output.

7. Method for communicating data of a printed circuit

7

board (12), the said board (12) comprising:

- a first portion (20) having first electronic components (22) of which the earth electrode is on a first voltage source (14);
- a second portion (24) having second electronic components (26) of which the earth electrode is on a second voltage source (16);
- a switched-mode power supply circuit (34) of which one input is connected to the first portion (20) and of which at least one output is connected to the second portion (24); the method comprising a step of modifying a switching frequency of the switched-mode power supply circuit (34) depending on values of data (32) to be transmitted between the first portion (20) and the second portion (24), the said data being able to take at least two distinct values,

the said modification step being carried out by modification means for modifying a switching frequency of the switched-mode power supply circuit (34) depending on data values (32) to be transmitted between the first portion (20) and the second portion (24), the said modification means (36) comprising a first resistor (70) and a capacitor (72),
each distinct value of the data corresponds to a distinct range of switching frequencies,
the data signal (32) is a logic signal and the number of distinct switching frequency ranges is equal to 2, and
the modification means (36) comprising an MOS transistor (74) and a second resistor (76) both being connected in series parallel to the first resistor (70), the gate of the MOS transistor (74) being connected to the data signal (32).

8. Compressor housing (6) comprising a printed circuit board (12) according to any one of Claims 1 to 6.

Fig. 1

Fig. 2

34

40

50

42

14 $E_{DC}$

52 +

54 $V_O$

44

46

48

## Fig. 3

$I_{42}$

Ip

60

$t_{ON}$        T        t

$I_{44}$

Ip X $N_1/N_2$

62

$t_{ON}$        $t_2$        T        t

$V_{42}$

$V_O$ X $N_1/N_2$

64

$t_{ON}$        $t_2$        T        t

M1        M2        M3

$V_{54}$

66

0        $V_O$

t

## Fig. 4

Fig. 5

Fig. 6

**EP 2 538 538 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5949659 A